# EUROPEAN PATENT APPLICATION

(11) **EP 1 763 070 A1**
(43) Date of publication of application: **14.03.2007**
(21) Application number: 05739084.1
(22) Date of filing: 12.05.2005
(51) Int. Cl.: H01L 21/301, C09J 7/02, C09J 163/00, H01L 21/52

(54) **ADHESIVE SHEET FOR BOTH DICING AND DIE BONDING AND SEMICONDUCTOR DEVICE MANUFACTURING METHOD USING THE ADHESIVE SHEET**

(30) Priority: 12.05.2004 JP 2004142274
(71) Applicant: SHARP KABUSHIKI KAISHA, Osaka-shi, Osaka 545-8522 (JP); Lintec Corporation, Tokyo 173-0001 (JP)
(72) Inventor: FUKUI, Yasuki, 5998241 (JP); YAMAZAKI, Osamu, Saitama-shi, Saitama 3360026 (JP); SAIKI, Naoya, 3430806 (JP)
(74) Representative: Kador & Partner
(86) International application number: PCT/JP2005/008728
(87) International publication number: WO 2005/109479

(57) **Abstract**

The objective of the present invention is, in so-called "a stacked type semiconductor device", as well as to reduce the damage caused to bonding wires in stacking, to solve problems resulting from poor accuracy in the thickness of the adhesive layer bonding semiconductor chips together, such as variation in the height of the semiconductor device, variation in the height from the substrate to the surface of the semiconductor chip in the uppermost layer and inclination of the semiconductor chip in the uppermost layer and the like.

The adhesive sheet for dicing and die bonding relating to the present invention, which achieves the above object, comprises a base material and an adhesive layer releasably laminated on said base material,
wherein said adhesive layer has a pressure sensitive adhering property at room temperature and a thermosetting property, the elastic modulus of the adhesive layer before thermosetting is 1.0×10³ to 1.0×10⁴ Pa, the melt viscosity at 120°C of the adhesive layer before thermosetting is 100 to 200 Pa·s, and the time required for the melt viscosity to reach its minimum value is 60 sec or less when the adhesive layer before thermosetting is maintained at a constant temperature of 120°C.

## Description

### [Technical Field]

The present invention relates to an adhesive sheet for dicing and die bonding and a manufacturing method of a stacked type semiconductor device using the same.

### [Background Art]

In order to realize speeding-up and miniaturization of semiconductor devices, a plurality of semiconductor chips (hereinafter simply referred to as chips) are sometimes two-dimensionally mounted within a single substrate. Such a semiconductor device is referred to as a multi-chip module. As a more miniaturized configuration, there is a device in which chips are three-dimensionally stacked. A package in which chips are three-dimensionally stacked in this way is also referred to as "a stacked type semiconductor device".

As such a device, there have been proposed a device in which small chips are stacked on large chips (See Japanese Patent Laid-open Publication No. S57-34466 and Japanese Patent Laid-open Publication No. H7-38053), a device in which chips are stacked with the shifted positions (See Japanese Patent Laid-open Publication No. S57-34466), a device in which chips with gap of step formed in the peripheral portion are stacked (See Japanese Patent Laid-open Publication No. H6-244360), a device in which two chips are bonded in a back-to-back fashion, one chip is directly bonded to a substrate and the other chip is connected to the substrate through a bonding wire (See Japanese Patent Laid-open Publication No. H7-273275) and the like.

However, each of the devices with the above-mentioned configurations has the following disadvantages.
In the configuration in which small chips are stacked on large chips, as is obvious, the chips of the same size cannot be stacked. In the case chips are stacked in the shifted positions, it has a structural disadvantage that electrode pads cannot be provided in the entire peripheral portion of the chips. Typically, in many of commercially available chips, a pad is formed in the entire peripheral portion. In the case where a limitation is imposed on the chip position, a problem occurs that these chips cannot be used.

In the configuration in which chips with gap of step formed in the peripheral portion are stacked, since a space around the electrode pad is originated due to the presence of the gap of step, the bonding wire is not damaged if chips of the same size are stacked. However, this configuration has a drawback that a process for forming gap is required, and accordingly the yield of the chip is lowered. Moreover, the mechanical strength is reduced in the peripheral portion of the chip because of the smaller plate thickness, and there were cases that mechanical damage was caused in wire bonding.

In the configuration with chips bonded in a back-to-back fashion, there are inconveniences that only up to two chips can be stacked, that bumps are required to be formed on the electrode pad for bonding the chip directly to the substrate and that the modes for connecting the chip to the substrate are different between the two chips, requiring two kinds of bonders, a die bonder for a flip-chip and a wire bonder.
In order to solve such problems, Patent Document 1 discloses a semiconductor device in which a plurality of semiconductor chips are stacked on a substrate, wherein electrode pads are formed in the peripheral portion of the semiconductor chips, the electrode pads and the substrate are connected through bonding wires, and an adhesive layer having a thickness of 25 µm or more and 300 µm or less is interposed between the semiconductor chips.

According to the invention of Patent Document 1, it has advantages that chips of the same size can be three-dimensionally stacked without performing a special processing to the chips or imposing any specific limitations on the sizes of the chips, the location of electrode pads or the like.
However, since the adhesive layer in Patent Document 1 is formed by coating and curing a liquid adhesive agent, the thickness and the region of the adhesive layer are difficult to control, thereby causing problems such as the contamination of the substrate and the semiconductor chips due to bleeding of the adhesive agent composing the adhesive layer and the inclination of the stacked semiconductor chips.

Particularly, in the case where semiconductor chips are stacked forming a multi-layer configuration, stable production problematically becomes difficult, for example, position recognition for performing wire bonding on the upper surface of the semiconductor chip may fail because of increased variation in the height of the semiconductor device, increased variation in the height from the substrate to the surface of the semiconductor chip in the uppermost layer, increased inclination of the semiconductor chip in the uppermost layer and the like. That is, in the case where the number of layers stacked is two, the above-mentioned variations and inclination do not bring about serious concern; however, as the number of the semiconductor chips stacked increases to 3 or 4 and so on, the above-mentioned variations and inclination increase, the problem that it is difficult to stably produce the semiconductor device is induced.

Patent Document 2 discloses a semiconductor device in which a plurality of semiconductor chips are stacked on a substrate and electrode terminals provided in each of the semiconductor chips are electrically connected to the substrate through bonding wires, wherein an insulating layer is formed between the bonding wire and a semiconductor chip stacked on the bonding wire side of the semiconductor chip to which the bonding wire is connected. This semiconductor device is produced either, as described in Claim 11 in Patent Document 2, by "a manufacturing method of a semiconductor device, comprising a sheet attaching step in which a sheet comprising an insulating layer and an adhesive layer is attached to a wafer before divided into semiconductor chips so that the insulating layer side of the sheet is brought into contact with the wafer, a dividing step in which the wafer to which the sheet is attached is divided into semiconductor chips by dicing and an adhering step in which the semiconductor chip, to which the adhesive layer is attached, is adhered through said adhesive layer to a semiconductor chip electrically connected to a substrate by bonding wires"; or, as described in Claim 12 in Patent Document 2, by "a manufacturing method of a semiconductor device, comprising an insulating layer attaching step in which an insulating layer sheet comprising an insulating layer is attached to a wafer before divided into semiconductor chips, an adhesive layer attaching step in which, after said insulating layer attaching step, an adhesive layer sheet comprising an adhesive layer is attached to the surface to which the insulating layer sheet is attached of the wafer, a dividing step in which the wafer, to which the insulating layer sheet and the adhesive layer sheet are attached, is divided into semiconductor chips by dicing and an adhering step in which the semiconductor chip to which the adhesive layer is attached is adhered through said adhesive layer to a semiconductor chip electrically connected to a substrate by bonding wires."

It is described that the insulating layer is preferably a resin that has excellent heat resistance and exhibits less plastic deformation at 100°C to 200°C, especially a polyimide-type resin. (See Paragraph 0060)
It is considered that an insulating layer comprising such a resin is attached to a wafer by thermocompression using a roller or the like because the pressure sensitive adhering property is typically low at room temperature. Accordingly, in the method described in Claim 11 of Patent Document 2, excessive pressure is applied to the adhesive layer when the sheet comprising the insulating layer and the adhesive layer is attached to the wafer, thereby sometimes impairing the thickness accuracy of the adhesive layer. If the thickness accuracy of the adhesive layer is impaired in this way, as the case of the liquid adhesive agent in Patent Document 1 described above, stable production problematically becomes difficult because of increased variation in the height of the semiconductor device, increased variation in the height from the substrate to the surface of the semiconductor chip in the uppermost layer, increased inclination of the semiconductor chip in the uppermost layer and the like.

Furthermore, in the method described in Claim 12 of Patent Document 2, in which the adhesive layer is attached after the insulating layer is attached, it is considered that thermocompression is performed in attaching the adhesive layer because the adhesive layer described in Patent Document 2 comprises a thermosetting resin and has no pressure sensitive adhering property. Therefore, as the manufacturing method described in Claim 11, excessive pressure is applied to the adhesive layer in attaching the adhesive layer, thereby sometimes impairing the thickness accuracy of the adhesive layer and likely causing various problems similar to those noted above.

Moreover, Patent Document 2 (Paragraph 0063) describes that "as the adhesive layer 6, preferred are thermosetting resins that are melted to a liquid from a solid by heating and then cured, and among them especially preferred is an epoxy resin." However, there are no specific descriptions on the desired melting and curing properties required for the adhesive layer.
If the adhesive layer is hard, the bonding wire is crushed and damaged, whereas if the adhesive layer is simply soft in nature, there is a possibility that the chip may be inclined due to nonuniformity in pressure in bonding or the adhesive agent may bleed out of the edges and causes contamination of the bonding pad of the upper chip. If the bonding pad is contaminated with the adhesive agent, wire bonding may fail or breaking of wire is likely to occur.
[Patent Document 1] Japanese Patent Laid-open Publication No. H10-027880
[Patent Document 2] Japanese Patent Laid-open Publication No. 2002-222913

### [Disclosure of the Invention]

### [Problems to be Solved by the Invention]

The object of the present invention is, in the above-mentioned so-called "a stacked type semiconductor device", as well as to reduce the damage caused on bonding wires in stacking, to solve problems resulting from poor accuracy in the thickness of the adhesive layer bonding the semiconductor chips together, such as variation in the height of the semiconductor device, variation in the height from the substrate to the surface of the semiconductor chip in the uppermost layer, the inclination of the semiconductor chip of the uppermost layer and the like.

### [Means to solve the Problems]

The adhesive sheet for dicing and die bonding relating to the present invention comprises a base material and an adhesive layer releasably laminated on said base material,
wherein said adhesive layer has a pressure sensitive adhering property at room temperature and a thermosetting property, the elastic modulus of the adhesive layer before thermosetting is 1.0×10³ to 1.0×10⁴ Pa, the melt viscosity at 120°C of the adhesive layer before thermosetting is 100 to 200 Pa·s, and the time required for the melt viscosity to reach its minimum value is 60 sec or less when the adhesive layer before thermosetting is maintained at a constant temperature of 120°C.

In the present invention, it is preferable that said adhesive layer has energy-beam curability, and the adhesive layer after energy beam curing but before thermosetting exhibits the properties described in Claim 1.
The adhesive sheet for dicing and die bonding of the present invention is suitably used for bonding and fixing chips in a stacked type semiconductor device.
That is, the manufacturing method of the stacked type semiconductor device relating to the present invention, characteristically comprises,
attaching the adhesive sheet for dicing and die bonding described above to the rear surface of a semiconductor wafer provided with semiconductor chips constituting the second layer or an upper layer thereof in the stacked type semiconductor device,
carrying out full-cut dicing of said semiconductor wafer together with the adhesive layer for dividing into individual semiconductor chips,
picking up the semiconductor chip having the adhesive layer on the rear surface from the base material,
preparing separately a substrate on which a wire-connected semiconductor chip constituting the first layer is mounted, and heating said substrate,
embedding the adhesive layer surface of said semiconductor chip into the wiring surface of said substrate,
bringing into contact the adhesive layer surface with the surface of the semiconductor chip constituting the first layer,
curing the adhesive layer thermally after the contact.

In the above description, when the adhesive layer has energy beam curability, the adhesive layer is irradiated with energy beam before or after full-cut dicing.
In such a manufacturing method of a stacked type semiconductor device of the present invention, it is preferable to use an adhesive sheet for dicing and die bonding in which the thickness of the adhesive layer is by 5 to 50 µm greater than the wire height.

### [Effects of the Invention]

The present invention, in the so-called "a stacked type semiconductor device", can reduce the damage caused on bonding wires in stacking and also solve the problems resulting from poor accuracy in the thickness of the adhesive layer bonding the semiconductor chips together, such as variation in the height of the semiconductor device, variation in the height from the substrate to the surface of the semiconductor chip in the uppermost layer and the inclination of the semiconductor chip in the uppermost layer and the like, thereby contribute to improving the quality and productivity of semiconductor devices.

### [Brief Explanation of Drawings]

[Figure 1] Fig. 1 shows an adhesive sheet for dicing and die bonding relating to the present invention.
[Figure 2] Fig. 2 shows one step in the manufacturing method relating to the present invention.
[Figure 3] Fig. 3 shows one step in the manufacturing method relating to the present invention.
[Figure 4] Fig. 4 shows one step in the manufacturing method relating to the present invention.
[Figure 5] Fig. 5 shows one example of a stacked type semiconductor device obtained by the present invention.

### [Explanation of Symbols]

- 1: Adhesive sheet for dicing and die bonding
- 2: Base material
- 3: Adhesive layer
- 4: Ring frame
- 5: Semiconductor wafer
- 6: Semiconductor chip (chip to be stacked (the second layer))
- 10: Substrate
- 11, 13: Wire
- 12: Semiconductor chip (bottom chip (the first layer))

### [Best Modes for Carrying Out the Invention]

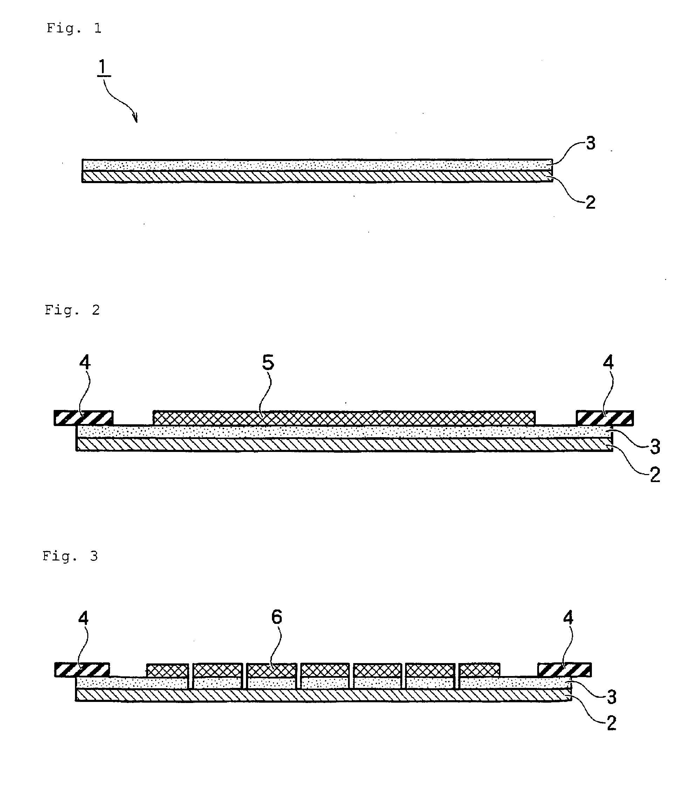

Hereinafter, the present invention is more specifically explained with reference to the drawings.
As shown in Fig. 1, an adhesive sheet for dicing and die bonding 1 relating to the present invention comprises a base material 2 and an adhesive layer 3 releasably laminated on the base material 2. The adhesive sheet 1 may be any form such as a tape form, a label form and the like.
Hereinafter, the base material 2 and the adhesive layer 3 are individually explained.

### "Base material 2"

As the base material 2 in the adhesive sheet 1, there may be used, for example, a film such as polyethylene film, polypropylene film, polybutene film, polybutadiene film, polymethylpentene film, polyvinyl chloride film, vinyl chloride copolymer film, polyethylene terephthalate film, polyethylene naphthalate film, polybutylene terephthalate film, polyurethane film, ethylene-vinyl acetate film, ionomer resin film, ethylene-(meth)acrylic acid copolymer film, ethylene-(meth)acrylate ester copolymer film, polystyrene film, polycarbonate film, polyimide film, a fluororesin film and the like. A crosslinked film thereof may also be used. Further, a laminated film thereof may be used. Moreover, such a film may be a transparent film, a colored film or an opaque film. In the case where the adhesive layer 3 described later is light (ultraviolet)-curable, a transparent film or a colored transparent film is selected.

In the manufacturing method of a semiconductor device relating to the present invention, as described later, the base material 2 and the adhesive layer 3 are releasably laminated so that the chip is picked up from the base material 2 with the adhesive layer 3 remained sticking onto the rear surface of the chip. For this purpose, the surface tension of the surface of the base material 2 contacting with the adhesive layer 3 is preferably 40 mN/m or lower, more preferably 37 mN/m or lower, especially preferably 35 mN/m or lower. A base material having such a low surface tension can be obtained by selecting an appropriate material or by applying releasing treatment in which the surface of the base material is coated with a release agent such as a silicone resin, an alkyd resin and the like.

The film thickness of the base material 2 is typically 10 to 500 µm, preferably 15 to 300 µm, especially preferably approximately 20 to 250 µm.

### "Adhesive Layer 3"

The adhesive layer 3 has a pressure sensitive adhering property at room temperature, a thermosetting property and preferably also has energy beam curability.

In the adhesive sheet 1 of the present invention, the adhesive layer 3 is used both for fixing a wafer in wafer dicing and eventually bonding the semiconductor chips together. Especially, in the manufacturing method of a stacked type semiconductor device of the present invention described later, a semiconductor wafer is diced while fixed with the adhesive sheet 1, subsequently a semiconductor chip having the adhesive layer on the rear surface is picked up from the base material, and the adhesive layer surface of the semiconductor chip is gradually embedded into the wiring surface of a substrate so as to bring the surface of the adhesive layer 3 into contact with a surface of a semiconductor chip constituting the first layer. At this time, the wiring surface is heated to a temperature slightly higher than the melting point of the adhesive layer and not higher than the curing temperature. For this reason, if the adhesive layer is too soft, the accuracy in thickness of the adhesive layer may be decreased.

Therefore, in the present invention, the elastic modulus of the adhesive layer 3 before thermosetting is 1.0 × 10³ to 1.0 × 10⁴ Pa, preferably 1.0 × 10³ to 5.0 × 10³ Pa. Note that the elastic modulus of the adhesive layer 3 is measured at 100°C by using a dynamic viscoelasticity measuring apparatus at a measurement frequency of 1 Hz. When the elastic modulus of the adhesive layer 3 before thermosetting falls within the above range, the adhesive layer is not readily deformed in manufacturing a stacked type semiconductor device and the accuracy in the thickness of the adhesive layer is maintained.

In pressing for adhering of the semiconductor chips, if the adhesive layer 3 is too hard, the wire may be crushed or broken. On the other hand, if the adhesive layer 3 is too soft, the adhesive is fluidized, causing various problems resulting from poor accuracy in the thickness of the adhesive layer. Therefore, the adhesive layer 3 in pressing for adhering of the semiconductor chips, that is, the adhesive layer 3 before thermosetting, is required to have an appropriate melting property.

For this reason, the melt viscosity at 120°C of the adhesive layer 3 before thermosetting is 100 to 200 Pa·s, preferably 110 to 190 Pa·s. Note that the melt viscosity at 120°C of the adhesive layer 3 is measured by using a dynamic viscoelasticity measuring apparatus at a measurement frequency of 1 Hz.
Moreover, when the adhesive layer before thermosetting is maintained at a constant temperature of 120°C, the time required for the melt viscosity to reach its minimum value is 60 sec or less, preferably 50 sec or less, more preferably 40 sec or less. An adhesive containing a polymer in the composition takes time to attain uniformity in viscosity in the whole sample even when the temperature is high. Therefore, when the temperature is increased and then maintained constant, the viscosity of the adhesive agent is gradually decreased. However, since the adhesive has a thermosetting property, the viscosity increases with time due to thermosetting. Note that the time required for the melt viscosity at 120°C to reach its minimum value for the adhesive layer 3 is measured by using a dynamic viscoelasticity measuring apparatus at a measurement frequency of 1 Hz.

When the adhesive layer surface comes into contact with the heated wire, the adhesive layer is locally heated and the viscosity locally decreases only in the adhesive layer close to the wire. Consequently, the wire is quickly embedded into the adhesive layer, thereby reducing the damage of the wire. To the adhesive area far away from the heated wire and from the heated chip body, heat is transmitted with delay, and the viscosity in this portion is not substantially decreased till the adhesion layer reaches the semiconductor chip body. Thus, the wire is not damaged and the deformation of the whole adhesive can be minimized. Accordingly, the possibility of trouble such as the bleeding out of the adhesive is reduced and the thickness accuracy of the adhesive layer can be maintained.

Furthermore, in the present invention, the adhesive layer 3 may have not only a thermosetting property but also energy beam curability. In this case, the above-mentioned properties of the adhesive layer refer to those after energy beam curing and before thermosetting.
The adhesive layer 3 basically comprises a pressure sensitive adhesive component (A) and a thermosetting component (B) as essential components and preferably contains an energy beam-curable component (C), and where necessary, other additives (D) are blended.

### Hereinafter, the components (A) to (D) are explained. "Pressure Sensitive Adhesive Component (A)"

Typically, an acrylic polymer is preferably used as the pressure sensitive adhesive component (A). The repeating unit of the acrylic polymer includes a repeating unit derived from a (meth)acrylate ester monomer or a (meth)acrylic acid derivative. The (meth)acrylic acid ester monomer used here includes a cycloalkyl (meth)acrylate, benzyl (meth)acrylate, and an alkyl (meth) acrylate in which the alkyl group has 1 to 18 carbon atoms. Among them, an especially preferred one is an alkyl (meth)acrylate in which the alkyl group has 1 to 18 carbon atoms, for example, methyl acrylate, methyl methacrylate, ethyl acrylate, ethyl methacrylate, propyl acrylate, propyl methacrylate, butyl acrylate, butyl methacrylate and the like. As the (meth) acrylic acid derivative, there may be mentioned, for example, glycidyl (meth)acrylate and the like.

Particularly, the acrylic polymer preferably contains a glycidyl (meth) acrylate unit and at least one kind of alkyl (meth)acrylate unit. In this case, the content of the component unit derived from glycidyl (meth)acrylate in the copolymer is typically 0 to 80% by mass, preferably 5 to 50% by mass. The introduction of a glycidyl group improves compatibility with an epoxy resin used as a thermosetting component described below and increases Tg after curing, thus improving heat resistance. It is preferred to use, as the alkyl (meth)acrylate, methyl (meth)acrylate, ethyl (meth)acrylate, butyl (meth)acrylate or the like. Further, when a hydroxyl group-containing monomer such as hydroxyethyl acrylate is introduced, it becomes easy to control the adhesiveness to the adherend and cohesiveness.

The weight average molecular weight of the acrylic polymer is preferably 100000 or more, more preferably 150000 to 1000000.

### "Thermosetting Component (B)"

The thermosetting component (B) has a character that it is not cured with energy beam but forms a three-dimensional network to tightly bond to an adherend upon heating. Such a thermosetting component (B) is generally composed of a thermosetting resin such as epoxy, phenol, resorcinol, urea, melamine, furan, unsaturated polyester, silicone and the like and a suitable hardening accelerator. A variety of such thermosetting components are known, and various publicly known conventional thermosetting components may be used without particular limitations in the present invention. As an example of such thermosetting components, there may be mentioned a pressure sensitive adhesive component comprising an epoxy resin (B-1) and a heat activated latent curing agent for epoxy resins (B-2).

As the epoxy resin (B-1), various publicly known conventional epoxy resins may be used. Typically, it is preferred to use an epoxy resin having a weight average molecular weight of approximately 300 to 2000, and it is particularly preferred to use a blend of an epoxy resin that is liquid in an ordinary state and has a weight average molecular weight of 300 to 500, preferably 330 to 400, and an epoxy resin that is solid in an ordinary state and has a weight average molecular weight of 400 to 2000, preferably 500 to 1500. The epoxy equivalent weight of the epoxy resin preferably used in the present invention is typically 50 to 5000 g/eq. As such epoxy resins, there may be mentioned, specifically, a glycidyl ether of phenols such as bisphenol A, bisphenol F, resorcinol, phenyl novolac and cresol novolac; a glycidyl ether of alcohols such as butanediol, polyethylene glycol and polypropylene glycol; a glycidyl ether of a carboxylic acid such as phthalic acid, isophthalic acid and tetrahydrophthalic acid; a glycidyl-type or an alkylglycidyl-type epoxy resin in which an active hydrogen bonded to a nitrogen atom in aniline, isocyanurate or the like is substituted with a glycidyl group; a so-called alicyclic epoxide such as vinylcyclohexene diepoxide, 3,4-epoxycyclohexylmethyl-3,4-dicyclohexanecarboxylate, 2-(3,4-epoxy)cyclohexyl-5,5-spiro(3,4-epoxy)cyclohexane-m-dioxane in which epoxy groups are introduced, for example, by oxidizing carbon-carbon double bonds in the molecule. Moreover, there may be used a dicyclopentadiene skeleton-containing epoxy resin having a dicyclopentadiene skeleton and a reactive epoxy group in the molecule.

Among them, in the present invention, it is preferred to use a bisphenol-based glycidyl-type epoxy resin, an o-cresol novolac-type epoxy resin or a phenol novolac-type epoxy resin.
One of these epoxy resins can be used alone or two or more kinds thereof may be used in combination.

The heat activated latent curing agent for epoxy resins (B-2) is a type of curing agent that is not reacted with an epoxy resin at room temperature but activated by heating to a temperature higher than a certain temperature to react with an epoxy resin.
As methods for activating the heat activated latent curing agent for epoxy resins (B-2), there are a method of forming active species (anion and cation) through chemical reaction induced by heat; a method in which the curing agent (B-2), which is stably dispersed in the epoxy resin (B-1) around room temperature, becomes compatible with or soluble in the epoxy resin at a higher temperature to initiate curing reaction; a method using a curing agent included in molecular sieves, which leaches to initiate curing reaction at a high temperature; a method using microcapsules; and the like.

One of these heat activated latent curing agents for epoxy resins may be used alone or two or more kinds thereof may be used in combination. Among these, dicyandiamide, an imidazole compound or a mixture thereof is especially preferred.
The heat activated latent curing agent for epoxy resins (B-2) as mentioned above is typically used at a ratio of 0.1 to 20 parts by mass, preferably 0.5 to 15 parts by mass, especially preferably 1 to 10 parts by mass, with respect to 100 parts by mass of the epoxy resin (B-1).

### "Energy Beam Curable Component (C)"

The adhesive layer preferably comprises an energy beam-curable component (C) blended therein. Since the adhesive force of the adhesive layer can be reduced by curing the energy beam curable component (C), the interlayer separation between the base material and the adhesive layer becomes possible to be readily carried out.

The energy beam curable component (C) is a compound that is polymerized and cured upon irradiation with energy beam such as ultraviolet light, electronic beam and the like. As the energy beam polymerizable compound, there may be used, specifically, an acrylic compound such as trimethylolpropane triacrylate, tetramethylolmethane tetraacrylate, pentaerythritol triacrylate, dipentaerythritol monohydroxy pentaacrylate, dipentaerythritol hexaacrylate, 1,4-butylene glycol diacrylate, 1,6-hexanediol diacrylate, polyethylene glycol diacrylate, oligoester acrylate, a urethane acrylate-type oligomer, epoxy-modified acrylate, polyether acrylate and oligo(itaconic acid). Such compounds have at least one polymerizable double bond in the molecule and typically have a weight average molecular weight of 100 to 30000, preferably approximately 300 to 10000.

Further, as another example of the energy beam polymerizable compound, a dicyclopentadiene skeleton-containing compound and the like may be used.
The energy beam curable component (C) is used at a ratio of 0 to 50 parts by mass, preferably 1 to 30 parts by mass, especially preferably approximately 2 to 20 parts by mass, with respect to 100 parts by mass of the total of the components (A) and (B) described above.

The adhesive composition containing the energy beam curable component (C) as described above is cured by irradiation with energy beam. Specifically, ultraviolet light, electronic beam and the like are used as the energy beam.
When ultraviolet light is used as the energy beam, adding a photopolymerization initiator may reduce the polymerization curing time and irradiation dose.

As such a photopolymerization initiator, there may be mentioned, specifically, benzophenone, acetophenone, benzoin, benzoin methyl ether, benzoin ethyl ether, benzoin isopropyl ether, benzoin isobutyl ether, benzoin benzoic acid, benzoin methyl benzoate, benzoin dimethyl ketal, 2,4-dimethylthioxanthone, α-hydroxycyclohexylphenyl ketone, benzyl diphenyl sulfide, tetramethylthiuram monosulfide, azobisisobutyronitrile, benzil, dibenzyl, diacetyl, β-chloroanthraquinone and 2,4,6-trimethylbenzoyldiphenylphosphine oxide.

The photopolymerization initiator is preferably used at a ratio of 0.01 to 20 parts by mass, preferably approximately 0.1 to 15 parts by mass, with respect to 100 parts by mass of the energy beam curable component (C).

### "Other Components (D)"

A coupling agent (D1) may be blended in the adhesive layer. The coupling agent (D1) preferably has a group reactive with a functional group contained in the components (A) to (C), preferably in the component (B).

It is believed that the organic functional group in the coupling agent (D1) is reacted with the thermosetting component (B) (especially preferably an epoxy resin) during curing reaction, thus improving adhesiveness, removing resistance and further water resistance (wet heat resistance) without impairing the heat resistance of the cured material.
As the coupling agent (D1), a silane-based agent (silane coupling agent) is preferable in terms of its versatility, cost-benefit and the like. The coupling agent (D1) as mentioned above is used at a ratio of typically 0.1 to 20 parts by mass, preferably 0.3 to 15 parts by mass, especially preferably 0.5 to 10 parts by mass, with respect to 100 parts by mass of the thermosetting component (B).

In order to adjust the initial adhesive force and cohesive force, a cross-linking agent (D-2), such as an organic polyisocyanate compound, an organic polyimine compound and the like, can be added to the adhesive agent.
As the organic polyisocyanate compound, there may be mentioned an aromatic polyisocyanate compound, an aliphatic polyisocyanate compound, an alicyclic polyisocyanate compound, and a trimer of these polyisocyanate compounds; and an isocyanate-capped urethane prepolymer obtained by reacting these polyisocyanate compounds with a polyol compound. As a more specific example of the organic polyisocyanate compounds, there may be mentioned, for example, 2, 4-tolylene diisocyanate, 2,6-tolylene diisocyanate, 1,3-xylylene diisocyanate, 1,4-xylene diisocyanate, diphenylmethane-4, 4'-diisocyanate, diphenylmethane-2,4'-diisocyanate, 3-methyldiphenylmethane diisocyanate, hexamethylene diisocyanate, isophorone diisocyanate, dicyclohexylmethane-4, 4'-diisocyanate, dicyclohexylmethane-2,4'-diisocyanate, lysine isocyanate and the like.

As a specific example of the organic polyimine compound, there may be mentioned N,N'-diphenylmethane-4,4'-bis(1-aziridinecarboxyamide), trimethylolpropane tri-β-aziridinylpropionate, tetramethylolmethane tri-β-aziridinylpropionate, N,N'-toluene-2,4-bis(1-aziridinecarboxyamide), triethylene melamine and the like. The cross-linking agent (D2) as mentioned above is blended at a ratio of typically 0.1 to 20 parts by mass, preferably 0.2 to 10 parts by mass, with respect to 100 parts by mass of the pressure sensitive adhesive component (A) .

The adhesive layer may further contain a filler such as asbestos, silica, glass, mica, chromium oxide, titanium oxide, a pigment and the like. The filler may be blended at a ratio of approximately 0 to 400 parts by mass with respect to 100 parts by mass of the total of the components (except for the filler) composing the adhesive layer.
Moreover, in order to control the thermal response (melting property) of the adhesive layer, a thermoplastic resin having a glass transition point of 60°C to 150°C may be blended. As the thermoplastic resin, there may be mentioned, for example, polyester resin, polyvinyl alcohol resin, polyvinylbutyral, polyvinyl chloride, polystyrene, polyamide resin, cellulose, polyethylene, polyisobutylene, polyvinyl ether, polyimide resin, phenoxy resin, poly(methyl methacrylate), styrene-isoprene-styrene block copolymer, styrene-butadiene-styrene block copolymer and the like. Among them, a phenoxy resin is especially preferable because of excellent compatibility with other components of the adhesive layer.

The ratio of the thermoplastic resin to be blended in the adhesive layer is preferably 1 to 50 parts by mass, more preferably 2 to 40 parts by mass, especially more preferably 3 to 30 parts by mass, per 100 parts by mass of total of the pressure sensitive adhesive component (A) and the thermosetting component (B). When an acrylic polymer is used as the pressure sensitive adhesive component (A), the weight ratio of the acrylic polymer to the thermoplastic resin (acrylic polymer/thermoplastic resin) is preferably 9/1 to 3/7.

### "Adhesive"

The adhesive layer of the present invention has unique melting properties as mentioned above.

As the primary factor influencing the melting properties of the adhesive layer, there is mentioned a ratio of the pressure sensitive adhesive component (A) to the thermosetting component (B) in the blend. Since the pressure sensitive adhesive component (A) has a high molecular weight, the fluidity upon heating is more suppressed as the content increases, while the fluidity appears when the content is reduced. On the other hand, the thermosetting component (B) has a low molecular weight, is not changed on irradiation with energy beam, and exerts fluidity. Consequently, in order to achieve suitable fluidity and to prevent bleeding, the ratio of the pressure sensitive adhesive component (A) to that of the thermosetting component (B) in the blend is critical. The ratio of the thermosetting component (B) to be blended is preferably 10 to 99 parts by mass, more preferably 50 to 97 parts by mass, especially preferably 83 to 95 parts by mass in 100 parts by mass of the total amount ((A)+(B)) of the pressure sensitive adhesive component (A) and the thermosetting component (B).

Furthermore, in the case where the adhesive contains the energy beam curable component (C), the adhesive layer is die-bonded after curing the energy beam curable component. Consequently, if the adhesive layer contains much of the energy beam curable component, the cross-linking density increases and the adhesive layer is hardened, thereby reducing the fluidity and causing difficulties in die bonding.
Moreover, when the adhesive layer contains the thermoplastic resin in a large quantity, the fluidity becomes excessively high, and there may be a case that the desired elastic modulus and melt viscosity cannot be obtained.

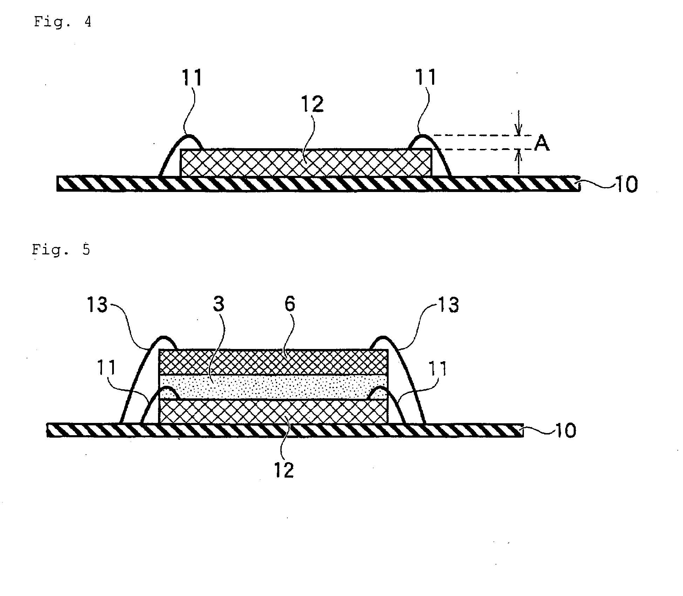

Therefore, in the case where the energy beam curable component (C) or the thermoplastic component is blended, the ratios of these components in the blend are appropriately selected within the above-mentioned range so as to meet the desired elastic modulus and melt viscosity.
The thickness of the adhesive layer comprising the above components is preferably by approximately 10 to 50 µm thicker than the wire height (the distance between the top of the wire and the top surface of the semiconductor chip to which the wire is connected, shown as "A" in Fig. 4). Although the wire height varies depending on the type and manufacturing method of a semiconductor device, it is typically approximately 20 to 80 µm. Therefore, the thickness of the adhesive layer is preferably 30 to 130 µm, and it is more preferably 40 to 100 µm in light of the coating workability. If the thickness of the adhesive layer is thin, the chip stacked thereon may be contacted with the wire to cause short circuit or the pressure at bonding may cause breaking.

The adhesive comprising each component as described above has pressure sensitive adhering property and thermal curability, contributes to fixing a wafer in dicing through tightly attaching to the base material, and can be used as an adhesive bonding the chip and the wiring surface in mounting. Especially the adhesive layer 3 of the present invention, owing to its unique melting properties as mentioned above, causes no damage to the wire when it is pressure-bonded to the heated wiring surface. Furthermore, the thickness accuracy of the adhesive layer is not impaired since the fluidization of the adhesive is reduced to the minimum required. A cured material with high impact resistance can be finally obtained through thermosetting. The adhesive layer is also excellent in balance between shear strength and peeling strength and maintains sufficient adhesiveness even under severe heat and humidity conditions.

### "Adhesive Sheet for dicing and die bonding 1"

The adhesive sheet for dicing and die bonding 1 has a configuration in which the adhesive layer 3 is releasably laminated on the base material 2, and a releasing film may be laminated in advance on the top surface of the adhesive layer in order to protect the adhesive layer 3. As the releasing film, there may be used a general-purpose releasing film, which is a film made of polyethylene terephthalate or the like subjected to releasing treatment using a releasing agent such as a silicone resin and the like.
The manufacturing method of such adhesive sheet for dicing and die bonding 1 is not particularly limited. The sheet may be produced by coating the base material 2 with a composition composing the adhesive layer 3 and then drying the layer, or may be produced by providing the adhesive layer on a releasing film and then transferring the layer to said base material.

Furthermore, an adhesive sheet for fixing a ring frame may be provided in the peripheral portion on the surface of the adhesive layer 3 in order to fix the ring frame.

### "Manufacturing Method of Stacked type Semiconductor Device"

Next, there is explained the manufacturing method of a stacked type semiconductor device relating to the present invention using the adhesive sheet for dicing and die bonding 1.

In the manufacturing method of the present invention, firstly, the adhesive sheet for dicing and die bonding is attached to the rear surface of a semiconductor wafer provided with semiconductor chips constituting the second layer or an upper layer thereof in the stacked type semiconductor device,
said semiconductor wafer is subjected to full-cut dicing together with the adhesive layer for dividing into individual semiconductor chips, and the semiconductor chip having the adhesive layer on the rear surface is picked up from the base material to obtain a semiconductor chip having the adhesive layer on the rear surface.

Specifically, as shown in Fig. 2, firstly, the adhesive sheet for dicing and die bonding 1 is fixed with the ring frame 4 on a dicing apparatus, one surface of a silicon wafer 5 is mounted onto the adhesive layer 3 of the adhesive sheet for dicing and die bonding 1 and gently pressed to fix the wafer 5.
After that, if the adhesive layer 3 has energy beam curability, it is irradiated with energy beam from the side of the base material 2, increasing the cohesive force of the adhesive layer 3 and decreasing the adhesive force between the adhesive layer 3 and the base material 2. The energy beam irradiation may be performed after dicing or after the expanding step described below.

Next, as shown in Fig. 3, by using a cutting means such as a dicing saw, the wafer 5 is cut into individual circuits to obtain semiconductor chips. The cutting depth at this time is set to a depth equal to the sum of the thickness of the silicone wafer and the thickness of the adhesive layer plus an offset for wear-out of the dicing saw, and the adhesive layer is cut together with the wafer 5.
After that, if the adhesive sheet for dicing and die bonding 1 is expanded as necessary, the interval between the semiconductor chips is widened to further facilitate picking up the semiconductor chip. At this time, a gap is formed between the adhesive layer and the base material, thereby reducing the adhesive force between the adhesive layer and the base material and facilitating picking up the chip.

By picking up the semiconductor chip in this way, it can be peeled from the base material while the adhesive layer 3, which has been cut, is remained sticking to the rear surface of the semiconductor chip 6.
On the other hand, apart from the above, as shown in Fig. 4, there is prepared a substrate 10 on which a semiconductor chip 12 with wires 11 connected, which composes the first layer, is mounted. The wire 11, which electrically connects the electrode terminal on the semiconductor chip 12 to the outer lead on the substrate 10, is typically composed of a gold wire or the like. The substrate 10 on which the semiconductor chip 12 is mounted with this configuration may be obtained by various publicly known methods. The substrate 10 and the semiconductor chip 12 are bonded through a typical thermosetting adhesive agent such as an epoxy-based adhesive agent or an adhesive layer of a general-purpose adhesive sheet for dicing and die bonding, or they may be bonded through the adhesive layer 3 of adhesive sheet for dicing and die bonding 1 of the present invention.

The adhesive layer 3 of the semiconductor chip 6 is pressed onto the wiring surface of the semiconductor chip 12 to stack the semiconductor chips. At this time, the wire 11 and the semiconductor chip 12 are heated in advance to a temperature higher than the melting point of the adhesive layer 3 by heating the substrate 10 under the chip 12. Since the adhesive layer 3 has highly specific melting properties as mentioned above, when the adhesive layer 3 comes into contact with the wire 11, the adhesive layer is quickly melted and softened in the contacting parts, while the melting and softening of the adhesive occurs more slowly in the part away from the wire because less heat is conducted from either the wire or the body of the lower chip. For this reason, the wire 11 becomes embedded into the adhesive layer 3 without being damaged, while the deformation due to melting and softening is suppressed to small in the part away from the wire. After that, the adhesive layer 3 becomes tightly attached to the surface of the semiconductor chip 12, and a given pressure is applied to the adhesive layer 3 with a bonding apparatus. At this time, the viscosity is maintained high in the most part of the adhesive layer because it is not yet sufficiently heated, and thus there happens neither bleeding out, that is, coming of the adhesive out of the edges of the semiconductor chip, nor the inclination of the chip due to nonuniformity in the bonding pressure. Later, the heat from the body of the lower chip reaches the adhesive layer 3 sufficiently via conduction. At this time, however, the application of pressure with the bonding apparatus is completed and the curing of the adhesive layer 3 proceeds, and therefore the deformation of the adhesive layer 3 can be suppressed.

If an adhesive agent having a melt viscosity at 120°C of lower than 100 Pa·s is used in place of the adhesive layer 3 of the present invention, although the damage caused to the wire 11 is small, bleeding out and the inclination of the chip are likely to occur since the viscosity of the whole adhesive is reduced at the time of applying pressure in bonding. Further, if one uses an adhesive in which the time required for the melt viscosity to reach its minimum value is longer than 60 sec, the whole adhesive needs to be sufficiently preheated in order to prevent damaging the wire since the local decrease in viscosity does not readily take place. However, if the whole adhesive is preheated, the adhesive is deformed, and bleeding out and the inclination of the chip are likely to occur. If the whole adhesive is not preheated, the wire 11 is crushed and damaged.

In this way, the semiconductor chip 6 is stacked as the second layer on the semiconductor chip 12, and electrode chips of the semiconductor chip 6 are connected to the outer leads of the substrate 10 through wires 13, providing a stacked type semiconductor device of two-layer structure shown in Fig. 5. A semiconductor chip may be stacked as the third layer on the surface of semiconductor chip 6, which is the second layer, and wire boding may be performed in the same way as above. Further, still more chips may be stacked as the fourth layer and the fifth layer.

In the stacked type semiconductor device obtained in this way, since the adhesive layer having highly specific melting properties is used, crushing and breaking of the wire are unlikely to occur, and various problems due to the poor thickness accuracy of the adhesive layer are solved.
The stacked type semiconductor device obtained may be subjected to a variety of finishing treatments that are publicly known in the production of semiconductor devices such as resin sealing, as necessary.

### (Examples)

Hereinafter, the present invention is explained with Examples, but the present invention is not limited to these

### examples.

In Example and Comparative Examples below, the following procedures were employed to evaluate "elastic modulus", "melt viscosity", "time required for the melt viscosity to reach its minimum value", "bonding area to the bottom chip", "damage to a wire", "bleeding" and "package reliability".

### "Elastic modulus", "Melt viscosity" and "Time required for the melt viscosity to reach its minimum"

Each of the adhesive layers of Example and Comparative Examples was formed in a layer having a thickness of 3 mm, and both of the surfaces were irradiated with ultraviolet light. The elastic modulus and the melt viscosity at 100°C of these samples were measured by using a dynamic viscoelasticity analyzer (manufactured by Rheometric Scientific Inc., RDA II) at the measurement frequency of 1 Hz. In addition, by using the same apparatus and frequency, the temperature of the samples was raised from room temperature to 120°C at a rate of 1.0°C/sec and maintained constant at 120°C, and then the time-viscosity profile was recorded. The time required for the melt viscosity to reach its minimum value was determined from the profile.

### "Bonding area to the bottom chip"

For the semiconductor devices produced in Example and Comparative Examples, the stacking interface between the semiconductor chip in the first layer and the semiconductor chip in the second layer was observed with an ultrasonic flaw detector to determine the bonding area.

### "Damage to a wire"

For the semiconductor devices produced in Example and Comparative Examples, the continuity test was performed for the wire connected to the semiconductor chip in the first layer to examine whether the wire was damaged or not.

### "Bleeding"

After the semiconductor chip in the second layer was bonded onto the upper surface of the semiconductor chip in the first layer in Example and Comparative Examples, the state of the edge surface of the chip was observed with an optical microscope prior to resin sealing.

The bleeding was rated at "yes" when it was observed that the adhesive agent came onto the upper surface of the chip in the second layer exceeding the edge surface, while the bleeding was rated at "no" when such a phenomenon was not observed. "Package reliability"
The packages of the semiconductor devices produced in Example and Comparative Examples were kept under the conditions of 30°C and a relative humidity of 70% for 120 hr to allow the packages to absorb moisture. Then, the IR reflow was conducted twice at the maximum temperature of 240°C, and the presence of floating and peeling at the bonding portions and the presence of the package cracking were examined with a scanning ultrasonic flaw detector and by cross section observation.

### "Adhesive layer"

The compositions of the adhesive are shown as follows. These are common to Example and Comparative Examples.
(A) Pressure sensitive adhesive component: A copolymer having a weight average molecular weight of approximately 800, 000 and a glass transition temperature of -28°C, which was obtained by copolymerizing 55 parts by mass of butyl acrylate, 10 parts by mass of methacrylic acid, 20 parts by mass of glycidyl methacrylate and 15 parts by mass of 2-hydroxyethyl acrylate
(B) Thermosetting component: A mixture of ingredients described below was used:

30 parts by mass of bisphenol A-type liquid epoxy resin containing acrylic rubber fine particles dispersed (BPA 328, produced by Nippon Shokubai Co., Ltd., epoxy equivalent weight: 230);
40 parts by mass of bisphenol A-type solid epoxy resin (1055 produced by Nippon Shokubai Co., Ltd., epoxy equivalent weight: 875 to 975);
10 parts by mass of o-cresol novolac-type epoxy resin (EOCN, produced by Nippon Kayaku Co., Ltd., epoxy equivalent weight: 213 to 223);
1 part by mass of dicyandiamide curing agent (Adeka Hardener 3636AS produced by Asahi Denka Co., Ltd.); and
1 part by mass of imidazole hardening accelerator (Curesol 2PHZ produced by Shikoku Chemicals Corporation)
   (C) Energy beam curable components:
      C1: dipentaerythritol hexaacrylate (Kayarad DPHA produced by Nippon Kayaku Co., Ltd.)
      C2: photopolymerization initiator (2,4,6-trimethylbenzoyldiphenylphosphine oxide)
   (D) Other components:
      D1: silane coupling agent (MKC silicate MSEP2 produced by Mitsubishi Chemical Corporation)
      D2: polyisocyanate-type cross-linking agent (an adduct of trimethylolpropane and toluylene diisocyanate)

### (Example 1)

### (1) Production of an adhesive sheet for dicing and die bonding

The adhesive composition blended as described in Table 1 was applied on the surface, which was subjected to releasing treatment with a silicone resin, of a releasing film (SP-PET 3811, produced by Lintec Corporation, having a thickness of 38 µm) by using a roll knife coater so that the thickness of the dried film would be 50 µm and dried, and the film was laminated on a base material having a thickness of 100 µm (an ethylene-methyl methacrylate copolymer film having a surface tension of 35 mN/m) to obtain an adhesive sheet.

As an adhesive sheet for fixing a ring frame, there was prepared an adhesive sheet (a shape in which a circle having an inside diameter of 165 mm was cut out) in which a removable type acrylic adhesive (10 µm) was formed on a polyvinyl chloride film (80 µm). The adhesive surface of the adhesive sheet prepared above and the polyvinyl chloride film surface were laminated, and the laminate was cut in a doughnut shape of concentric circles having an outside diameter of 207 mm to obtain an adhesive sheet for dicing and die bonding having an adhesive sheet for fixing a ring frame in the circumference.

### (2) Production of a semiconductor chip having an adhesive layer

A dummy circuit (aluminum wiring) having a bonding pad portion was formed on a mirror surface of a silicon wafer having a diameter of 100 mm by sputtering. The rear surface of the silicon wafer was grounded to a thickness of 200 µm with a wafer grinding apparatus.

Next, the adhesive sheet for dicing and die bonding obtained in (1) was attached onto the rear surface of the silicon wafer and fixed to a ring frame for dicing (2-6-1, produced by Disco Corporation). Subsequently, the adhesive sheet was irradiated with ultraviolet light from the side of the base plate surface using an ultraviolet irradiation apparatus (Adwill RAD2000, manufactured by Lintec Corporation). Next, the silicon wafer was diced into a chip having a size of 5.0 × 5.0 mm using a dicing machine (AWD-4000B, manufactured by Tokyo Seimitsu Co. Ltd.). At this time, the adhesive sheet was cut exceeding the adhesive layer so as to reach a depth of 10 µm in the base material.

### (3) Production of a two-layered stacked type semiconductor device

As a dummy substrate for IC packaging, there was prepared a glass epoxy substrate (90 µm) coated with a solder resist. The portion without coating with solder resist in one surface of the dummy substrate was subjected to the patterning treatment sequentially with copper foiling, nickel plating and gold plating to make a terminal for wire bonding, and the terminal was connected to an area for mounting a solder ball which was provided on the opposite surface of the dummy substrate through a via-hole.

The semiconductor chip having an adhesive layer produced in the above (2) (which was still fixed to the adhesive sheet for dicing and die bonding) was picked up with a die bonder (CPS-100, manufactured by NEC Machinery Corporation), and the chip was pressure-bonded to the die pad portion of the dummy substrate under the conditions of 120°C, 150 MPa and 1 sec, and subsequently the adhesive layer was cured at 160°C for 60 min, thereby mounting the semiconductor chip in the first layer. Next, the die pad portion of the semiconductor chip in the first layer and the die pad portion of the substrate were wire-bonded using a wire bonder (UTC-400, manufactured by Shinkawa Ltd.).
At this time, the wire height was approximately 40 µm.

Further, by using the same apparatuses and under the same conditions as the case of the semiconductor chip in the first layer, the die bonding step and the wire bonding step were performed for a semiconductor chip in the second layer on the upper surface of the semiconductor chip in the first layer.
Subsequently, the chip-mounted side of the substrate was molded into a given form with a molding resin (which contained a biphenyl-type epoxy resin and a phenol novolac resin), and the resin was cured at approximately 175°C for 6 hr to seal. Next, a solder ball having a diameter of 0.45 µm was attached to the unsealed side of the substrate by a given method to complete a two-layered stacked type IC package of BGA (Ball Grid Allay) configuration.

### (Comparative Examples 1 and 2)

Except that the compositions of Comparative Examples 1 and 2 in Table 1 were used, the evaluations were made in the same manner as Example 1. The results are shown in Table 1.

**[Table 1]**

| | Example 1 | Comparative Example 1 | Comparative Example 2 |
|---|---|---|---|
| (A) Pressure sensitive adhesive component | 10 | 20 | 0 |
| (B) Thermosetting component | 82 | 82 | 82 |
| (C1) DPHA | 2.9 | 12 | 0 |
| (C2) Photopolymerization initiator | 0.1 | 0.36 | 0 |
| (D1) Silane coupling agent | 0.6 | 0.6 | 0.6 |
| (D2) Polyisocyanate | 0.2 | 0.2 | 0.2 |
| Elastic modulus (Pa) | 2.0×10³ | 3.5×10⁴ | 5.0×10² |
| Melt viscosity (Pa·s) | 150 | 3380 | 80 |
| Time required for the melt viscosity to reach its minimum value(sec) | 26 | 191 | 13 |
| Bonding area to the bottom chip (%) | 100 | 80 | 100 |
| Damage to a wire | No | Yes | No |
| Bleeding | No | No | Yes |
| Package reliability | Good | Poor | Poor |

### [Industrial Applicability]

The present invention, in the so-called "a stacked type semiconductor device", can reduce the damage caused to bonding wires in stacking and solve problems resulting from poor accuracy in the thickness of the adhesive layer bonding semiconductor chips together, such as variation in the height of the semiconductor device, variation in the height from the substrate to the surface of the semiconductor chip in the uppermost layer and inclination of the semiconductor chip in the uppermost layer and the like, contributing to improve the quality and productivity of semiconductor devices.

## Claims

1. An adhesive sheet for dicing and die bonding comprising a base material and an adhesive layer releasably stacked on said base material,
wherein said adhesive layer has a pressure sensitive adhering property at room temperature and a thermosetting property, the elastic modulus of the adhesive layer before thermosetting is 1.0×10³ Pa to 1.0×10⁴ Pa, the melt viscosity at 120°C of the adhesive layer before thermosetting is 100 to 200 Pa·s, and the time required for the melt viscosity to reach its minimum value is 60 sec or less when the adhesive layer before thermosetting is maintained at a constant temperature of 120°C.

2. The adhesive sheet for dicing and die bonding according to Claim 1, wherein said adhesive layer has energy beam curability and the adhesive layer after cured by energy-beam but before thermosetting exhibits the properties in Claim 1.

3. The adhesive sheet for dicing and die bonding according to either Claim 1 or Claim 2, wherein said adhesive sheet is used for bonding and fixing semiconductor chips to each other in a stacked type semiconductor device.

4. A manufacturing method of a stacked type semiconductor device, wherein
the adhesive sheet for dicing and die bonding according to Claim 1 is attached to the rear surface of a semiconductor wafer provided with semiconductor chips constituting the second layer or a upper layer thereof in the stacked type semiconductor device,
said semiconductor wafer is subjected to full-cut dicing together with the adhesive layer for dividing into individual semiconductor chips,
the semiconductor chip having the adhesive layer on the rear surface is picked up from the base material,
separately, prepared is a substrate on which a wire-connected semiconductor chip constituting the first layer is mounted, said substrate is heated,
the adhesive layer surface of the semiconductor chip is embedded into the wiring surface of said substrate, the adhesive layer surface is brought into contact with the surface of semiconductor chip constituting the first layer, and then
the adhesive layer is thermally cured.

5. A manufacturing method of a stacked type semiconductor device, wherein
the adhesive sheet for dicing and die bonding according to Claim 2 is attached to the rear surface of a semiconductor wafer provided with semiconductor chips constituting the second layer or a upper layer thereof in the stacked type semiconductor device,
said semiconductor wafer is subjected to full-cut dicing together with the adhesive layer for dividing into individual semiconductor chips, the adhesive layer is irradiated with energy beam before or after the full-cut dicing, the semiconductor chip having the adhesive layer on the rear surface is picked up from the base material,
separately, prepared is a substrate on which a wire-connected semiconductor chip constituting the first layer is mounted, said substrate is heated,
the adhesive layer surface of said semiconductor chip is embedded into the wiring surface of said substrate, the adhesive layer surface is brought into contact with the surface of the semiconductor chip constituting the first layer, and then
the adhesive layer is thermally cured.

6. The manufacturing method of a stacked type semiconductor device according to either Claim 4 or Claim 5 using an adhesive sheet for dicing and die bonding in which the thickness of the adhesive layer is by 5 to 50 µm thicker than the wire height.
